# FASCICULE DE BREVET EUROPEEN

(11) **EP 0 373 062 B1**
(45) Date de publication et mention de la délivrance du brevet: **21.07.1993**
(21) Numéro de dépôt: 89403361.2
(22) Date de dépôt: 05.12.1989
(51) Int. Cl.: H03F 1/30, H03F 3/45

(54) **Circuit d'asservissement de la tension de repos d'une charge, et comparateur différentiel comportant ce circuit d'asservissement**
Schaltung zur Steuerung der Ruhespannung einer Last und Differenzvergleicher mit einer derartigen Steuerschaltung
Control circuit for the rest potential of a charge, and differential comparator comprising such a control circuit

(30) Priorité: 09.12.1988 FR 8816217
(43) Date de publication de la demande: 13.06.1990
(73) Titulaire: THOMSON-CSF SEMICONDUCTEURS SPECIFIQUES, 75008 Paris (FR)
(72) Inventeur: Campagnie, Bertrand, F-92045 Paris la Défense (FR)
(74) Mandataire: Taboureau, James

(56) Documents cités:
- FR-A- 2 624 324
- US-A- 4 577 162
- US-A- 4 707 624

## Description

La présente invention concerne un circuit d'asservissement de la tension de repos d'un dispositif comportant une charge constituée par une source de courant. Elle s'applique notamment aux comparateurs différentiels dans lesquels deux signaux d'entrées sont comparés par deux transistors qui sont chargés chacun par une source de courant, elle même formée par un transistor dont la grille et la source sont reliés. Le circuit selon l'invention assure en outre, dans ce cas, l'auto-calibration, c'est-à-dire la compensation d'offset entre les deux branches du comparateur.

Il est connu qu'un transistor dont la source et la grille sont reliés ensemble (Vgs = 0) constitue une source de courant qui débite un courant constant, proportionnel à la taille du transistor. Mais, en raison des très petites dimensions des transistors actuels, qui se comptent en micromètres, et surtout dans le domaine des hyperfréquences, il n'est pas toujours possible d'obtenir une pluralité de transistors qui soient rigoureusement identiques entre eux. Par conséquent, deux sources de courant conçues identiques peuvent ne pas être réalisées rigoureusement identiques pour des questions de technologie.

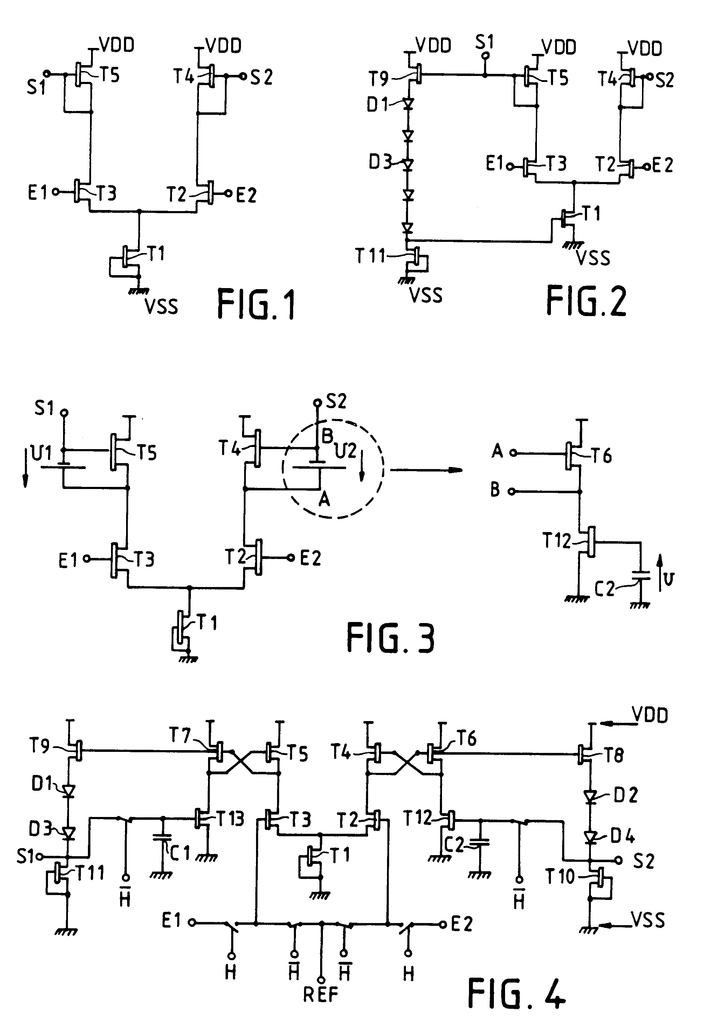

Ainsi, considérons un comparateur différentiel simple connu, tel que celui de la figure 1 : il comprend deux transistors T2 et T3 dont les grilles forment les entrées E1 et E2 du comparateur. Ces deux transistors sont alimentés par une source de courant T1, et chargés par deux transistors T4 et T5, montés en sources de courants, et sur les grilles desquels sont prises les sorties S1 et S2. Si le courant imposé par la source de courant T1 n'est pas, pour des raisons technologiques, rigoureusement égal à celui imposé par les sources de courant T4 et T5, il en résulte une différence importante entre les niveaux de repos moyens en S1 et S2. On appelle niveaux de repos moyens les tensions obtenues lorsque les signaux d'entrées en E1 et E2 sont égaux et au milieu de la dynamique.

A titre d'exemple, un écart de 10 % sur la largeur de grille de T4 ou T5 entraîne le niveau de repos à saturation, ce qui rend l'utilisation de ce comparateur très délicate. Il y a donc nécessité à stabiliser ce comparateur, surtout s'il travaille en hyperfréquence, donc avec des largeurs de grilles submicroniques.

En outre, si le courant imposé par T4 n'est pas rigoureusement égal à celui imposé par T5, les niveaux de repos de S1 et S2 ne sont pas les mêmes : une tension dite d'offset apparaît.

On connaît un dispositif de stabilisation tel que celui représenté en figure 2. A un comparateur tel que celui de la figure 1 est ajoutée une boucle de contrôle comprenant un transistor suiveur T9, une pluralité de diodes D1...D3... et une source de courant T11. Le signal de sortie S1 est appliqué sur la grille du transistor T9 et la tension prélevée entre diodes et source de courant T11 est appliquée sur la grille de la source de courant T1. Ce circuit contrôle le niveau de repos de S2 en ajustant le courant dans T1.

Un tel dispositif, bien que satisfaisant dans certains cas, présente cependant quelques imperfections :
- l'amplitude des signaux de sortie en S2 est deux fois plus grande que celle en S1 car le circuit est non symétrique
- le translateur nécessaire à la boucle de stabilisation, c'est-à-dire la rangée de diodes, a un très mauvais comportement en température
- ce système ne réalise pas l'autocalibration : l'offset entre S1 et S2 n'est pas compensé.

Le circuit selon l'invention permet de résoudre les deux problèmes exposés : celui de l'autostabilisation si l'on considère une source de courant seule, et celui de l'autocalibration, ou suppression d'offset, si l'on considère un système symétrique tel qu'un comparateur. Ce circuit introduit, entre grille et source d'un transistor de charge monté en source de courant, une tension réglable fournie par un pseudo-générateur. Ce dernier est constitué par une capacité chargée au cours d'une phase de calibration, commandée par une horloge. La tension aux bornes de la capacité est variable, en fonction du niveau de sortie lorsqu'une tension de référence est injectée à l'entrée. Cette tension variable permet d'ajuster le Vgs du transistor monté en source de courant.

Si deux circuits selon l'invention sont montés de façon symétrique sur les deux transistors de charge d'un comparateur différentiel :
- la fraction commune aux deux tensions variables des deux pseudo-générateurs stabilise les niveaux de repos moyens des sorties S1 et S2
- la différence entre ces deux tensions compense l'offset entre les sorties S1 et S2.

De façon plus précise, l'invention concerne un circuit d'asservissement de la tension de repos d'un dispositif comportant un transistor de charge monté en source de courant, caractérisé en ce qu'il comporte :
- des moyens d'asservissement de la tension grille-source Vgs dudit transistor, ces moyens étant constitués par un circuit suiveur-translateur qui agit en pseudo-générateur de tension,
- des moyens de contrôle de la tension de décalage dudit circuit suiveur-translateur par la charge stockée dans une capacité,
- des moyens de charge de ladite capacité par un circuit décaleur qui, pendant une phase de calibration, prélève la tension de sortie du dispositif et la réinjecte sur la capacité de stockage.

L'invention sera mieux comprise par la description détaillée qui en est faite maintenant, en s'appuyant sur les figures jointes en annexe, qui représentent :
- figure 1 : schéma électrique d'un comparateur différentiel connu,
- figure 2 : schéma électrique d'un circuit connu de stabilisation d'un comparateur différentiel, ces deux figures ayant été préalablement expliquées,
- figure 3 : schéma électrique d'équivalence du circuit selon l'invention,
- figure 4 : schéma d'application du circuit selon l'invention à un comparateur différentiel.

Il a été précisé que l'invention concerne un circuit d'asservissement de la tension de repos d'un transistor monté en source de courant : cependant, l'exposé de l'invention sera plus clair, et ses avantages ressortiront mieux, si l'on considère un système symétrique tel qu'un comparateur, muni de deux circuits d'asservissements selon l'invention. Ceci ne constitue pas une limitation à la portée de l'invention.

De même, les schémas représentent des transistors à effet de champ, mais l'invention est également applicable aux transistors bipolaires. Qu'ils soient en silicium ou en matériaux III-V tel que GaAs, ces transistors sont cependant tous normalement passants.

L'invention, dans son fondement, est représentée sur la partie gauche de la figure 3, dont la partie droite donne la réalisation. Considérons un circuit tel que le comparateur différentiel de la figure 1, dans lequel les liaisons directes grille-source des deux transistors de charge T4 et T5 (Vgs = 0V) sont remplacées par deux pseudo-générateurs qui fournissent des tensions U1 et U2.

Les problèmes du comparateur différentiel simple seraient résolus si l'on pouvait ajuster à leur juste valeur les tensions des pseudo-générateurs U1 et U2. En effet, en ajustant U1 et U2, on ajuste les tensions grilles-sources Vgs4 et Vgs5 de T4 et T5. Et de ce fait, les courants dans T4 et dans T5 s'en trouvent modifiés.

La fraction de tension commune à U1 et à U2 permet de corriger les niveaux de repos moyens des sorties S1 et S2, ce qui assure la stabilisation du mode commun, ou fonction d'autostabilisation.

La différence de tension entre U1 et U2 permet de compenser l'offset et assure la fonction d'autocalibration.

Comme le montre la partie droite de la figure 3, ces pseudo-générateurs sont constitués, chacun, par une capacité C2, dont une électrode est mise à la masse et qui débite dans un suiveur formé des deux transistors en série T6 et T12, en ce qui concerne la tension U2. Cette capacité est chargée, au cours d'une phase de fonctionnement appelée phase de calibration, qui sera explicitée ultérieurement : pendant ladite phase, les signaux d'entrées E1 et E2 sont coupés et remplacés par un signal de référence. Le signal résultant sur une sortie S2 est réinjecté sur la capacité, dont la charge est donc variable. La tension entre A et B, à la grille et à la source du transistor T6 constitue la tension U2 (ou, symétriquement, la tension U1 pour l'autre branche du différentiel).

Ce fonctionnement nécessite un signal d'horloge H et son complément H̅ pour les phases de mesure et de calibration.

En résumé, le fonctionnement d'un tel circuit repose sur deux phases distinctes :
- une phase de calibration pendant laquelle les capacités se chargent de façon à obtenir les bonnes tensions de repos,
- une phase de mesure durant laquelle le comparateur assure sa fonction classique, mais avec des tensions de correction stockées dans les capacités.

La réalisation pratique de ce circuit d'asservissement est donnée en figure 4, sur laquelle deux circuits selon l'invention sont ajoutés aux deux branches d'un comparateur différentiel, ce qui en fait un comparateur auto-stabilisé (dont les niveaux de repos moyens des sorties S1 et S2 sont à des niveaux bien déterminés) et auto-calibré (dont les niveaux de repos moyens sont les mêmes).

On distingue sur ce schéma :
- le comparateur différentiel T1 à T5
- les deux suiveurs T6 + T12 et T7 + T13
- les deux décaleurs T8 + D2 + D4 + T10 et T9 + D1 + D3 + T11,
- les deux capacités de stockage C2 et C1,
- le circuit d'entrées par lequel sont appliqués les signaux E1, E2 et REF sur les grilles des transistors T2 et T3 du comparateur.

Le circuit d'entrée comporte, pour chaque voie, deux interrupteurs commandés l'un par le signal d'horloge H, l'autre par le complément H̅, pour injecter le signal de référence pendant la phase de calibration ou le signal d'entrée E1/E2 pendant la phase de mesure.

Pour chaque voie, la grille du transistor de charge T4 (T5) est reliée au point commun des deux transistors T6 + T12 (T7 + T13) du suiveur, et la source du même transistor de charge T4 (T5) est reliée aux grilles des transistors de charge T6 (T7) du suiveur et T8 (T9) du décaleur.

La tension présente au point commun au transistor d'alimentation T10 (T11) et à la dernière diode D4 (D3) du décaleur est prélevée d'une part comme tension de sortie S2 (S1) et d'autre part comme tension de charge de la capacité de stockage C2 (C1), à travers un interrupteur commandé par le complément d'horloge H̅.

En phase de calibration, les interrupteurs commandés par le complément d'horloge H̅ sont fermés, et les interrupteurs commandés par l'horloge H sont ouverts. En phase de mesure, l'inverse se produit.

Considérons le suiveur translateur T6 + T12 + C2. Les deux transistors normalement passants de ce circuit sont de taille identique et en série, ils se polarisent à des tensions Vgs identiques. La tension entre les points A et B (fig. 3) est donc égale à la tension U aux bornes de la capacité C2.

En phase de calibration, les signaux d'entrées E1 et E2 sont isolés par les deux interrupteurs commandés par l'horloge H. Chaque branche du comparateur voit son entrée reliée à la tension de référence REF, pour laquelle on désire que le comparateur bascule, et le signal de sortie - translaté d'environ deux volts s'il y a deux diodes pour chaque décaleur - se retrouve au point S1/S2, ce qui assure la charge de la capacité C1/C2.

En fait, le circuit étant rebouclé sur lui-même avec un gain de boucle G, la tension aux bornes de C1/C2 se stabilise, et l'écart de tension résiduel de la sortie par rapport à la masse est égal à l'écart initial, c'est-à-dire celui qu'il y aurait sans circuit de stabilisation, divisé par ce gain G. On réalise ainsi la fonction d'auto-stabilisation des niveaux de repos de chaque branche.

En phase de mesure, les interrupteurs commandés par l'horloge H injectent les signaux d'entrées E1/E2, tandis que les interrupteurs commandés par le complément H̅ isolent les capacités de stockage C1/C2. Celles-ci imposent leur tension U à la grille des transistors T12/T13 sources de courants pour les suiveurs translateurs.

De même que pour les niveaux moyens de repos, l'offset résiduel entre les deux sorties S1 et S2 est égal à l'offset initial divisé par le même gain G. On réalise ainsi la fonction d'autocalibration du comparateur différentiel.

En résumé, pour un circuit comportant au moins un transistor de charge T4 ou T5, le circuit selon l'invention assure :
- l'asservissement de la tension Vgs du transistor de charge T4 par un suiveur translateur : transistors T6 + T12 et capacité C2
- le contrôle de la tension de décalage de ce suiveur translateur par la charge d'une capacité C2
- le chargement de cette capacité lors d'une phase de calibration, le circuit étant alors rebouclé sur lui même durant cette phase.

Le circuit selon l'invention est appliqué aux dispositifs dans lesquels un transistor de charge fonctionne en source de courant, mais il est particulièrement intéressant dans le cas des comparateurs ou amplificateurs différentiels.

## Revendications

1. Circuit d'asservissement de la tension de repos d'un dispositif comportant un transistor de charge monté en source de courant (T4), caractérisé en ce qu'il comporte :
- des moyens d'asservissement de la tension grille-source Vgs dudit transistor (T4), ces moyens étant constitués par un circuit suiveur-translateur (T6 + T12) qui agit en pseudo-générateur de tension,
- des moyens de contrôle de la tension de décalage dudit circuit suiveur-translateur par la charge stockée dans une capacité (C2),
- des moyens de charge de ladite capacité par un circuit décaleur (T8 + D2 + D4 + T10) qui, pendant une phase de calibration, prélève la tension de sortie (S2) du dispositif et la réinjecte sur la capacité de stockage (C2).

2. Circuit d'asservissement selon la revendication 1, caractérisé en ce que ce circuit en boucle comporte :
- un circuit suiveur-translateur formés par deux transistors montés en série (T6 + T12), la grille et la source du premier transistor (T6) étant reliées respectivement à la source et à la grille du transistor de charge (T4)
- une capacité de stockage (C2), dont une armature est reliée à la grille du second transistor (T12) du suiveur-translateur, et dont l'autre armature est reliée à la masse du circuit,
- un circuit décaleur formé par un troisième transistor (T8) en série avec une pluralité de diodes (D2, D4) et avec un quatrième transistor (T10) monté en source de courant, la grille du troisième transistor (T8) étant reliée à la grille ou à la source du transistor de charge (T4), et le signal de sortie (S2), sur le drain du quatrième transistor (T10) étant rebouclé sur la capacité de stockage (C2) à travers un interrupteur commandé par un signal d'horloge (H).

3. Circuit d'asservissement selon la revendication 2, caractérisé en ce que les transistors sont de type normalement passant.

4. Circuit d'asservissement selon la revendication 2, caractérisé en ce que, G étant le gain de la boucle d'asservissement, la variation de la tension de repos de la sortie (S2) est égale à la variation de tension de repos initiale, sans circuit d'asservissement, divisée par le gain G de la boucle.

5. Comparateur différentiel, comportant un transistor source de courant (T1) et deux branches constituées chacune d'un transistor d'entrée (T2, T3) et d'un transistor de charge (T4, T5), ce comparateur étant caractérisé en ce que les tensions de repos de ses deux transistors de charges (T4, T5) sont asservies, chacune, par un circuit d'asservissement selon la revendication 2, et en ce qu'il comporte en outre, sur ses voies d'entrées, des interrupteurs commandés par un signal d'horloge (H) pour injecter les signaux d'entrées (E1, E2) sur les grilles des transistors d'entrées (T2, T3), et des interrupteurs commandés par un signal complément d'horloge (H̅) pour injecter un signal de référence (REF) à la place des signaux d'entrées (E1, E2).

6. Comparateur différentiel selon la revendication 5, caractérisé en ce que :
- pendant une phase de calibration commandée par le complément d'horloge H̅, le signal de référence (REF) est injecté sur les grilles des transistors d'entrées (T2, T3) et les signaux de sorties du comparateur (S1, S2) sont rebouclés sur les capacités de stockage (C1, C2) des deux circuits d'asservissement,
- pendant une phase de mesure, commandée par le signal d'horloge (H), le signal de référence (REF) est isolé, les bouclages entre les sorties (S1, S2) et les capacités de stockage (C1, C2) sont ouverts, et les tensions aux bornes de capacités (C1, C2) sont appliquées aux transistors de charge (T4, T5) des deux branches du comparateur.

7. Comparateur différentiel selon la revendication 5, caractérisé en ce que, G étant le gain des deux boucles d'asservissement, la tension d'offset entre les deux sorties (S1, S2) est égale à la tension d'offset initiale, sans les circuits d'asservissement, divisée par le gain G des boucles.

## Patentansprüche

1. Regelkreis für die Ruhespannung einer Vorrichtung mit einem als Stromquelle geschalteten Lasttransistor (T4), dadurch gekennzeichnet, daß er aufweist
- Regelmittel für die Spannung Vgs zwischen Gate- und Source-Elektrode dieses Transistors (T4) wobei diese Mittel aus einer Übersetzer-Folgeschaltung (T6 + T12) bestehen, die als Pseudospannungsgenerator wirkt,
- Mittel zur Regelung der Verschiebespannung der Übersetzer-Folgeschaltung durch die in einem Kondensator (C2) gespeicherte Ladung,
- Mittel zum Aufladen des Kondensators über eine Verschiebeschaltung (T8 + D2 + D4 + T10), die während einer Kalibrierphase die Ausgangsspannung (S2) der Vorrichtung abgreift und an den Speicherkondensator (C2) anlegt.

2. Regelkreis nach Anspruch 1, dadurch gekennzeichnet, daß die Rückkopplungsschleife enthält:
- eine Übersetzer-Folgeschaltung, die aus zwei in Reihe geschalteten Transistoren (T6 + T12) besteht, wobei die Gate-Elektrode und die Source-Elektrode des ersten Transistors (T6) an die Source-Elektrode bzw. Gate-Elektrode des Lasttransistors (T4) angeschlossen sind,
- einen Speicherkondensator (C2), der mit einem Belag an die Gate-Elektrode des zweiten Transistors (T12) der Übersetzer-Folgeschaltung und mit dem anderen Belag an die Masse des Kreises angeschlossen ist,
- einen Verschiebekreis, der von einem dritten Transistor (T8) in Reihe mit einer Mehrzahl von Dioden (D2, D4) und mit einem vierten Transistor (T10) gebildet wird, der als Stromquelle geschaltet ist, wobei die Gate-Elektrode des dritten Transistors (T8) an die Gate-Elektrode oder die Source-Elektrode des Lasttransistors (T4) angeschlossen ist und das Ausgangssignale (S2), von der Drain-Elektrode des vierten Transistors (T10) zum Speicherkondensator (C2) über einen von einem Taktsignal (H) gesteuerten Schalter zurückgeschleift ist.

3. Regelkreis nach Anspruch 2, dadurch gekennzeichnet, daß die Transistoren vom normalerweise leitenden Typ sind.

4. Regelkreis nach Anspruch 2, dadurch gekennzeichnet, daß die Schleifenverstärkung der Regelschleife den Wert G hat und die Veränderung der Ruhespannung des Ausgangs (S2) gleich der Veränderung der ursprünglichen Ruhespannung, also ohne Regelkreis, geteilt durch den Verstärkungsgrad G der Schleife ist.

5. Differentialkomparator mit einem als Stromquelle geschalteten Transistor (T1) und zwei Zweigen, die je einen Eingangstransistor (T2, T3) und einen Lasttransistor (T4, T5) besitzen, dadurch gekennzeichnet, daß die Ruhespannungen der beiden Lasttransistoren (T4, T5) je durch einen Regelkreis gemäß Anspruch 2 nachgeregelt sind und daß der Komparator außerdem in seinen Eingangskanälen von einem Taktsignal (H) gesteuerten Schalter, um die Eingangssignale (E1, E2) an die Gate-Elektroden der Eingangstransistoren (T2, T3) anzulegen, und von einem komplementierten Taktsignal (H) gesteuerte Schalter aufweist, um eine Bezugssignal (REF) anstelle der Eingangssignale (E1, E2) anzulegen.

6. Differentialkomparator nach Anspruch 5 dadurch gekennzeichnet, daß
- während einer Kalibrierphase, die vom komplementierten Taktsignal H gesteuert wird, das Bezugssignal (REF) an die Gate-Elektroden der Eingangstransistoren (T2, T3) angelegt wird und die Komparatorausgangssignale (S1, S2) an die Speicherkondensatoren (C1, C2) der beiden Regelkreise zurückgeschleift werden,
- während einer vom Taktsignal (H) gesteuerten Meßphase das Bezugssignal (REF) isoliert ist, die Schleifen zwischen den Ausgängen (S1, S2) und den Speicherkondensatoren (C1, C2) offen sind und die Spannungen an den Klemmen der Kondensatoren (C1, C2) an die Lasttransistoren (T4, T5) der beiden Zweige des Komparators angelegt werden.

7. Differentialkomparator nach Anspruch 5, dadurch gekennzeichnet, daß G der Verstärkungsgrad der beiden Regelschleifen ist und die Offsetspannung zwischen den beiden Ausgängen (S1, S2) gleich der ursprünglichen Offsetspannung, d. h. ohne Regelkreis, geteilt durch den Verstärkungsgrad G der Schleifen ist.

## Claims

1. Circuit for slaving the quiescent voltage of a device including a load transistor mounted as a current source (T4), characterised in that it includes :
- means for slaving the gate-source voltage Vgs of the said transistor (T4), these means consisting of a follower - converter circuit (T6 + T12) which acts as a voltage pseudo-generator,
- means for controlling the shift voltage of the said follower-converter circuit by the charge stored in a capacitor (C2),
- means for charging the said capacitor by a shifter circuit (T8 + D2 + D4 + T10) which, during a calibration phase, picks off the output voltage (S2) from the device and reinjects it onto the storage capacitor (C2).

2. Slaving circuit according to Claim 1, characterised in that this loop circuit includes:
- a follower-converter circuit formed by two transistors mounted in series (T6 + T12), the gate and the source of the first transistor (T6) being linked to the source and to the gate of the load transistor (T4) respectively.
- a storage capacitor (C2), one plate of which is linked to the gate of the second transistor (T12) of the follower-converter, whose other plate is linked to the earth of the circuit,
- a shifter circuit formed by a third transistor (T8) in series with a plurality of diodes (D2, D4) and with a fourth transistor (T10) mounted as a current source, the gate of the third transistor (T8) being linked to the gate or to the source of the load transistor (T4) and the output signal (S2), on the drain of the fourth transistor (T10), being looped back onto the storage capacitor (C2) through a switch controlled by a clock signal (H).

3. Slaving circuit according to Claim 2, characterised in that the transistors are of the normally conducting type.

4. Slaving circuit according to Claim 2, characterised in that, G being the gain of the slaving loop, the variation in the quiescent voltage of the output (S2) is equal to the initial quiescent voltage variation, without the slaving circuit, divided by the gain G of the loop.

5. Differential comparator, including a current source transistor (T1) and two branches each consisting of an input transistor (T2, T3) and of a load transistor (T4, T5), this comparator being characterised in that the quiescent voltages of its two load transistors (T4, T5) are each slaved, by a slaving circuit according to Claim 2, and in that it further includes, on its input channels, switches controlled by a clock signal (H) for injecting the input signals (E1, E2) onto the gates of the input transistors (T2, T3), and switches controlled by a clock complement signal (H) for injecting a reference signal (REF) in place of the input signals (E1, E2).

6. Differential comparator according to Claim 5, characterised in that:
- during a calibration phase controlled by the clock complement H, the reference signal (REF) is injected onto the gates of the input transistors (T2, T3) and the output signals (S1, S2) from the comparator are looped back onto the storage capacitors (C1, C2) of the two slaving circuits,
- during a measurement phase, controlled by the clock signal (H), the reference signal (REF) is isolated, the loopings between the outputs (S1, S2) and the storage capacitors (C1, C2) are open, and the voltages at the terminals of capacitors (C1, C2) are applied to the load transistors (T4, T5) of the two branches of the comparator.

7. Differential comparator according to Claim 5, characterised in that, G being the gain of the two slaving loops, the offset voltage between the two outputs (S1, S2) is equal to the initial offset voltage, without the slaving circuits, divided by the gain G of the loops.
